(19) Europäisches Patentamt
European Patent Office
Office européen des brevets

(11) **EP 3 224 631 B1**

(12) **EUROPÄISCHE PATENTSCHRIFT**

(45) Veröffentlichungstag und Bekanntmachung des Hinweises auf die Patenterteilung:
**01.08.2018 Patentblatt 2018/31**

(51) Int Cl.:
***G01R 31/26*** *(2014.01)*    ***G01K 7/01*** *(2006.01)*
***H02M 1/32*** *(2007.01)*

(21) Anmeldenummer: **15821054.2**

(22) Anmeldetag: **18.12.2015**

(86) Internationale Anmeldenummer:
**PCT/EP2015/080543**

(87) Internationale Veröffentlichungsnummer:
**WO 2016/124296 (11.08.2016 Gazette 2016/32)**

(54) **VERFAHREN ZUR BESTIMMUNG EINER ALTERUNG VON LEISTUNGSHALBLEITERMODULEN SOWIE VORRICHTUNG UND SCHALTUNGSANORDNUNG**

METHOD FOR DETERMINING THE AGEING OF POWER SEMICONDUCTOR MODULES AND DEVICE AND CIRCUIT ASSEMBLY

PROCÉDÉ DE DÉTERMINATION D'UN VIEILLISSEMENT DE MODULES SEMI-CONDUCTEURS DE PUISSANCE, DISPOSITIF ET CIRCUIT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.02.2015 EP 15153561**

(43) Veröffentlichungstag der Anmeldung:
**04.10.2017 Patentblatt 2017/40**

(73) Patentinhaber: **Siemens Aktiengesellschaft 80333 München (DE)**

(72) Erfinder:
• **BUTRON-CCOA, Jimmy Alexander 85604 Zorneding (DE)**
• **LINDEMANN, Andreas 39116 Magdeburg (DE)**
• **MITIC, Gerhard 81827 München (DE)**

(56) Entgegenhaltungen:
EP-A1- 2 615 467      DE-A1- 10 351 843
DE-A1-102012 222 481

EP 3 224 631 B1

**Beschreibung**

Die Erfindung betrifft ein Verfahren zum Charakterisieren eines Leistungshalbleitermoduls aufweisend zumindest ein Leistungshalbleiterbauelement. Die Erfindung betrifft außerdem eine Vorrichtung sowie eine Schaltungsanordnung.

Leistungshalbleitermodule sind bereits aus dem Stand der Technik bekannt und können beispielsweise einen Wechselrichter oder einen Umrichter umfassen. Leistungshalbleitermodule umfassen in der Regel zumindest einen Leistungshalbleiterchip beziehungsweise ein Leistungshalbleiterbauelement, welches insbesondere für das Steuern und Schalten hoher elektrischer Ströme und Spannungen ausgelegt ist. Ein solches Leistungshalbleiterbauelement kann beispielsweise ein Leistungs-Metall-Oxid-Feldeffekttransistor (Leistungs-MOSFET), eine Leistungsdiode oder ein Bipolartransistor mit isolierter Gate-Elektrode (insulated-gate bipolar transistor, kurz IGBT) sein. Die Leistungshalbleiterbauelemente werden zum Ausbilden des Leistungshalbleitermoduls üblicherweise auf ein Substrat gelötet und durch Bondverbindungen elektrisch miteinander verbunden.

Leistungshalbleitermodule können über ihre Lebensdauer charakterisiert werden. Die Lebensdauer des Leistungshalbleitermoduls ist eine Zeit bis zu einem Ausfall beziehungsweise einer Funktionsuntüchtigkeit des Leistungshalbleitermoduls. Während eines Betriebs des Leistungshalbleitermoduls kann sich eine verbleibende Lebensdauer des Leistungshalbleitermoduls, eine sogenannte Restlebensdauer des Leistungshalbleitermoduls, beispielsweise durch eine Alterung des Leistungshalbleitermoduls verändern. Dabei gilt insbesondere, dass sich die Restlebensdauer des Leistungshalbleitermoduls verkürzt, je schneller das Leistungsmodul altert.

Die Alterung des Leistungshalbleitermoduls wird in der Regel während des Betriebs, in welchem die Leistungshalbleitermodule thermischen und mechanischen Belastungen ausgesetzt sein können, beschleunigt. Diese thermischen und mechanischen Belastungen der Leistungshalbleitermodule können zu einer sogenannten thermomechanischen Ermüdung des Leistungshalbleitermoduls führen, welche den Ausfall beziehungsweise eine Funktionsuntüchtigkeit des Leistungshalbleitermoduls und damit ein Ende der Lebensdauer zur Folge haben kann. Thermische Belastungen können beispielsweise Temperaturwechselbelastungen durch den elektrischen Betrieb des Leistungshalbleitermoduls sein, welche insbesondere aufgrund unterschiedlicher thermischer Ausdehnungskoeffizienten der Materialien im Leistungshalbleitermodul zu einer Ermüdung der elektrischen Verbindungsstellen, beispielsweise von Bondverbindungen und Lötverbindungen des Chiplotes und des Systemlotes, führen können. Durch die Ermüdung der Verbindungsstellen können sich beispielsweise die Bondverbindungen oder die Lötverbindungen lösen, was zu einer erhöhten Temperatur des Halbleiterchips führt. Insgesamt wird also durch die thermomechanische Ermüdung des Leistungshalbleitermoduls die Alterung des Leistungshalbleitermoduls beschleunigt, was zu einer reduzierten Restlebensdauer und zu einem verfrühten Ausfall des Leistungshalbleitermoduls führen kann.

Um einen sicheren Betrieb des Leistungshalbleitermoduls innerhalb seines Anwendungsgebietes zu gewährleisten, ist eine Vorhersage der Lebensdauer des Leistungshalbleitermoduls wünschenswert. Gemäß dem Stand der Technik werden zum Vorhersagen der Lebensdauer der Leistungshalbleitermodule Lebensdauerberechnungen anhand von Lebensdauerkurven und vorgegebenen Lastprofilen rechnergestützt durchgeführt. Dazu wird beispielsweise eine Temperatur der Leistungshalbleitermodule überwacht, indem beispielsweise Thermistoren zusammen mit den Leistungshalbleiterbauelementen auf das Substrat gelötet werden. Jedoch lassen sich durch die räumliche Entfernung der Thermistoren zu den Leistungshalbleiterbauelementen die exakten transienten Temperaturen der Chips nicht genau erfassen, wodurch keine genauen Lebensdauerberechnungen durchgeführt werden können.

Auch ist aus dem Stand der Technik bekannt, thermische Ersatzschaltbilder für die Leistungshalbleitermodule zu erstellen, anhand welcher indirekt auf die Temperatur der Leistungshalbleiterbauelemente geschlossen werden kann. Über Strom- und Spannungsmessungen beziehungsweise über die Kenntnis des Arbeitspunktes des Leistungshalbleitermoduls lassen sich die elektrischen Verluste der IGBTs und der Dioden berechnen. Somit können zwar die Temperaturen der Leistungshalbleiterbauelemente im Betrieb berechnet werden, jedoch wird in den thermischen Ersatzschaltbildern in der Regel keine Alterung der Leistungshalbleiterbauelemente berücksichtigt.

Hierzu beschreibt die EP 2 615 467 A1 ein System zur Echtzeit-Überwachung des Betriebszustands eines IGBTs, insbesondere zum Bestimmen einer Sperrschichttemperatur und/oder einer verbleibenden Lebensdauer eines IGBTs. Hierbei werden eine Charakteristik einer Gate-Emitter-Spannung bestimmt und hieraus während einer Ausschaltphase Pulse bestimmt, welche einen Start und ein Ende eines Millerplateaus beschreiben. Anhand einer zeitlichen Verzögerung zwischen dem Start und dem Ende kann dann die Sperrschichttemperatur und/oder die verbleibenden Lebensdauer berechnet werden.

Zudem offenbart die DE 10 2012 222 481 A1 ein Verfahren zum Ermitteln einer Sperrschichttemperatur eines Leistungshalbleiters auf Grundlage einer bei einem Betrieb des Leistungshalbleiters gemessenen Verlustleistung des Leistungshalbleiters und einer Beziehung zwischen der Verlustleistung und einer temperaturabhängigen Impedanz des Leistungshalbleiters. Dabei wird die temperaturabhängige Impedanz auf Grundlage einer beim Betrieb des Leistungshalbleiters aufgenommenen Aufwärmkurve bestimmt.

Schließlich beschreibt die DE 103 51 843 A1 ein Verfahren zur Ermittlung einer Temperatur eines Leistungshalbleiters in einem Stromrichter. Hierbei wird mit Hilfe des Leistungshalbleiters ein Laststrom ein- und ausgeschaltet und die Größe des Laststroms wird überwacht Sofern die Größe des Laststroms einen vorgegebenen Wert aufweist oder in einem vorgegebenen Bereich um diesen Wert liegt, wird die an dem Leistungshalbleiter abfallende Spannung ermittelt. Aus dieser Spannung wird auf die Temperatur des Leistungshalbleiters geschlossen. Durch einen Vergleich mit vorgegebenen Grenztemperaturen für diesen Leistungshalbleitertyp oder durch einen Vergleich mit Temperaturen anderer typgleicher Leistungshalbleiter oder durch einen Vergleich mit früheren Temperaturen desselben Leistungshalbleiters ist es möglich, die Temperatur des Leistungshalbleiters zu überwachen.

Es ist Aufgabe der vorliegenden Erfindung, eine Lösung bereitzustellen, durch welche eine Alterung von Leistungshalbleitermodulen zuverlässiger bestimmt und dadurch eine Restlebensdauer der Leistungshalbleitermodule genauer vorhergesagt werden kann.

Diese Aufgabe wird erfindungsgemäß durch ein Verfahren, eine Vorrichtung sowie eine Schaltungsanordnung mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren.

Ein erfindungsgemäßes Verfahren dient zum Charakterisieren eines Leistungshalbleitermoduls mit zumindest einem Leistungshalbleiterbauelement. Bei dem Verfahren wird ein thermisches Modell des Leistungshalbleitermoduls zu einem Referenzzeitpunkt bestimmt, welcher vor einer Inbetriebnahme des Leistungshalbleitermoduls liegt, wobei zum Erstellen des thermischen Modells eine einen thermischen Pfad des Leistungshalbleitermoduls beschreibende thermische Impedanz des Leistungshalbleitermoduls bestimmt wird. Zudem wird eine Referenztemperatur anhand des thermischen Modells des Leistungshalbleitermoduls ermittelt, zumindest ein temperatursensitiver elektrischer Parameter (TSEP) des Leistungshalbleitermoduls zu zumindest einem gegenüber dem Referenzzeitpunkt späteren Zeitpunkt im Betrieb des Leistungshalbleitermoduls gemessen, eine aktuelle Temperatur des Leistungshalbleitermoduls aus dem zumindest einen gemessenen temperatursensitiven elektrischen Parameter des Leistungshalbleitermoduls ermittelt, eine Temperaturdifferenz zwischen der aktuellen Temperatur und der Referenztemperatur ermittelt und eine Alterung des Leistungshalbleitermoduls anhand der ermittelten Temperaturdifferenz bestimmt.

Das Leistungshalbleitermodul kann beispielsweise einen Wechselrichter oder einen Umrichter umfassen und weist bevorzugt einen IGBT als das zumindest eine Leistungshalbleiterbauelement auf. Um nun eine Lebensdauer des Leistungshalbleitermoduls vorherzusagen, wird die Alterung beziehungsweise ein Alterungsfortschritt des Leistungshalbleitermoduls bestimmt. Dazu wird für das Leistungshalbleitermodul das das Leistungshalbleitermodul charakterisierende thermische Modell zu dem Referenzzeitpunkt bestimmt. Das thermische Modell dient zur Beschreibung des thermischen Verhaltens des Leistungshalbleitermoduls. In dem thermischen Modell werden insbesondere Wärmequellen oder Wärmesenken innerhalb des Leistungshalbleitermoduls berücksichtigt. Solche Wärmequellen werden vorzugsweise über eine Verlustleistung des Leistungshalbleitermoduls, welche anhand von Strom- und Spannungsmessungen bestimmt werden kann, berechnet.

Zu dem Referenzzeitpunkt, zu welchem das thermische Modell bestimmt wird, weist das Leistungshalbleitermodul einen nicht gealterten Zustand, welcher auch als ein gesunder Zustand des Leistungshalbleitermoduls bezeichnet wird, auf, in welchem das Leistungshalbleitermodul insbesondere keine Ermüdungserscheinungen beziehungsweise Verschleißerscheinungen zeigt. Dieser Referenzzeitpunkt liegt vor einer Inbetriebnahme des Leistungshalbleitermoduls. Dies bedeutet, dass das Leistungshalbleitermodul noch keinen thermomechanischen Belastungen, welche üblicherweise zu der Ermüdung beziehungsweise beschleunigten Alterung des Leistungshalbleitermoduls führen, ausgesetzt war. Dieses zu dem Referenzzeitpunkt erstellte thermische Modell stellt also einen Anfangszustand des Leistungshalbleitermoduls dar.

Anhand dieses thermischen Modells wird die Referenztemperatur des Leistungshalbleitermoduls, welche einer sogenannten Sperrschichttemperatur entspricht, ermittelt. Durch diese Referenztemperatur wird der ungealterte Zustand beziehungsweise der gesunde Zustand des Leistungshalbleitermoduls charakterisiert. Beispielsweise kann bei einem thermischen Modell, welches das Leistungshalbleitermodul über die Verlustleistung charakterisiert, aus den bekannten Zusammenhängen zwischen Verlustleistung und Temperatur direkt die Referenztemperatur berechnet werden.

Nach Bestimmen der Referenztemperatur wird zu dem späteren Zeitpunkt, welcher zeitlich nach dem Referenzzeitpunkt liegt, zumindest ein temperatursensitiver elektrischer Parameter des Leistungshalbleitermoduls im Betrieb des Leistungshalbleitermoduls, beispielsweise in einem Wechselrichterbetrieb des den Wechselrichter aufweisenden Leistungshalbleitermoduls, gemessen. Während des Betriebs, also während einer bestimmungsgemäßen Verwendung des Leistungshalbleitermoduls, ist das Leistungshalbleitermodul thermomechanischen Belastungen ausgesetzt, durch welche das Leistungshalbleitermodul altern kann. Die Messung kann kontinuierlich oder zu vorbestimmten Messzeitpunkten während des Betriebs des Leistungshalbleitermoduls erfolgen.

Zur Messung des zumindest einen temperatursensitiven elektrischen Parameters des Leistungshalbleitermoduls kann beispielsweise eine entsprechende Messschaltung bereitgestellt werden. Auch kann vorgesehen sein, dass das Leistungshalbleitermodul oder das zumindest eine Leistungshalbleiterelement eine integrierte Messeinrichtung, beispielsweise eine Diode, aufweist, anhand welcher eine Temperaturüberwachung der Leistungshalbleitermodule durchgeführt werden kann.

Aus dem zumindest einen temperatursensitiven elektrischen Parameter wird eine aktuelle Temperatur, also eine Temperatur, welche das Leistungshalbleitermodul zu dem jeweiligen Messzeitpunkt aufweist, ermittelt beziehungsweise berechnet. Diese aktuelle Temperatur wird mit der Referenztemperatur verglichen und die Temperaturdifferenz zwischen der Referenztemperatur und der aktuellen Temperatur bestimmt.

Der Erfindung liegt die Erkenntnis zugrunde, dass sich während der Alterung des Leistungshalbleitermoduls beispielsweise durch Verschleißerscheinungen, insbesondere durch das bereits beschriebene Lösen von Bond- oder Lötverbindungen, eine Temperatur des Leistungshalbleitermoduls im Vergleich zu der Referenztemperatur des Leistungshalbleitermoduls im gesunden Zustand verändert. Durch das Lösen der Lötverbindung kann beispielsweise eine durch das Leistungshalbleiterbauelement im Betrieb produzierte Wärme nicht mehr oder nur schlecht über die Lötverbindung abgeführt werden. Dadurch kann sich die aktuelle Temperatur der Leistungshalbleitermoduls im Betrieb erhöhen.

Anhand der Temperaturdifferenz kann eine Alterung des Leistungshalbleitermoduls abgeschätzt beziehungsweise bestimmt werden. In einem ungealterten Zustand ist diese Temperaturdifferenz etwa Null. Mit fortschreitender Alterung und zunehmenden Verschleißerscheinungen erhöht sich die Temperaturdifferenz zunehmend, wobei die relative Änderung der Temperaturdifferenz einen Hinweis auf ein alterndes Leistungshalbleitermodul liefert.

Mittels des erfindungsgemäßen Verfahrens kann also auf besonders einfache Weise durch Ermitteln der Temperaturdifferenz eine Alterung des Leistungshalbleitermoduls bestimmt werden und damit eine Restlebensdauer beziehungsweise eine Verfügbarkeit des Halbleitermoduls vorhergesagt werden. Dadurch kann ein zuverlässiger Betrieb des Leistungshalbleitermoduls in seinem jeweiligen Anwendungsgebiet gewährleistet werden. Dadurch, dass die Alterung während des Betriebs beziehungsweise während der Betriebsphasen des Leistungshalbleitermoduls bestimmt wird, kann in vorteilhafter Weise eine Unterbrechung des Betriebs des Leistungshalbleitermoduls vermieden werden. Das Verfahren ist daher besonders anwenderfreundlich gestaltet.

Zusätzlich kann durch das Ermitteln der Alterung eine temperaturdifferenzabhängige Leistungsregelung des Leistungshalbleitermoduls zum Vermeiden von erhöhten Betriebstemperaturen und Temperaturwechselbelastungen bereitgestellt werden. Beispielsweise kann eine Steuereinrichtung bereitgestellt werden, welche anhand der ermittelten Temperaturdifferenz eine entsprechende Leistungsregelung für einen effizienten Betrieb des Leistungshalbleitermoduls durchführt. Somit kann durch den effizienten Betrieb des Leistungshalbleitermoduls einer fortschreitenden Alterung und damit einem verfrühten Ausfall des Leistungshalbleitermoduls entgegengewirkt werden.

Zum Erstellen des thermischen Modells wird eine einen thermischen Pfad des Leistungshalbleitermoduls beschreibende thermische Impedanz des Leistungshalbleitermoduls bestimmt. Die thermische Impedanz des Leistungshalbleitermoduls wird zu dem Referenzzeitpunkt, zu welchem das Leistungshalbleitermodul den Anfangszustand beziehungsweise den ungealterten Zustand aufweist, ermittelt beziehungsweise gemessen. Mittels der thermischen Impedanz kann der thermische Pfad des Leistungshalbleitermoduls beschrieben beziehungsweise parametrisiert werden. Die thermische Impedanz ist ein Wärmekennwert und ein Maß für einen Temperaturunterschied, welcher in dem Leistungshalbleitermodul, beim Hindurchtreten eines Wärmestromes entsteht. Bei Leistungshalbleitermodulen, welche eine Zusammenschaltung mehrere Leistungshalbleiterbauelemente aufweisen, setzt sich die thermische Impedanz des Leistungshalbleitermoduls aus den einzelnen thermischen Impedanzen der Leistungshalbleiterbauelemente zusammen. Die thermische Impedanz kann beispielsweise aus einem thermischen Ersatzschaltbild berechnet werden. Dazu können die das thermische Verhalten beschreibenden Kenngrößen in elektrische Größen übertragen werden. Mit diesen elektrischen Größen kann ein elektrisches Netzwerk erstellt werden, welches analytisch oder mittels eines Schaltungssimulators berechnet werden kann. Durch das Ermitteln der thermischen Impedanz kann ein besonders genaues und verlässliches Modell des Leistungshalbleitermoduls bestimmt werden.

Bevorzugt wird zum Erstellen des thermischen Modells eine Verlustleistung beziehungsweise eine Wärmeleistung des Leistungshalbleitermoduls bestimmt. Die Wärmeleistung beziehungsweise die Verlustleistung wird insbesondere in dem Arbeitspunkt des Leistungshalbleitermoduls durch Messen der Ausgangsspannung und des Ausgangsstroms des Leistungshalbleitermoduls und durch Bilden des Produktes von Ausgangsspannung und Ausgangsstrom berechnet. Anhand der Bestimmung der Wärmeleistung des Leistungshalbleitermoduls kann auf besonders einfache Weise das thermische Modell erstellt werden.

Vorzugsweise wird zum Erstellen des thermischen Modells eine Temperatur eines Kühlkörpers des Leistungshalbleitermoduls im Betrieb des Leistungshalbleitermoduls erfasst. Ein solcher Kühlkörper kann beispielsweise eine Kühlplatte sein, deren Temperatur im Betrieb des Leistungshalbleitermoduls gemessen wird. Der Kühlkörper als eine Wärmequelle beziehungsweise eine Wärmesenke kann also ebenfalls in dem thermischen Modell berücksichtigt werden, wodurch das thermische Modell besonders genau und zuverlässig gestaltet ist.

Vorzugsweise wird als der zumindest eine temperatursensitive elektrische Parameter des Leistungshalbleitermoduls, welches als das zumindest eine Leistungshalbleiterbauelement bevorzugt einen IGBT aufweist, zumindest eine der folgenden Größen gemessen: eine elektrische Schwellenspannung, also eine Gate-Emitter-Spannung, ein Millerplateau, eine Einschaltverzögerungszeit des Leistungshalbleitermoduls, eine Ausschaltverzögerungszeit des Leistungshalbleitermoduls, eine Stromanstiegsgeschwindigkeit, eine Sperrverzugsladung beziehungsweise eine Sperrverzögerungsladung, ein Tailstrom, welcher die Ausschaltverluste des Leistungshalbleitermoduls charakterisiert, eine Spannungsspitze des Leistungshalbleitermoduls während eines Einschaltvorgangs, eine Einschaltdauer des Leistungshalbleitermoduls oder eine Ausschaltdauer des Leistungshalbleitermoduls. Da jede dieser Größen temperaturabhängig ist, kann aus den gemessenen Werten dieser Größen auf besonders einfache Weise eine aktuelle Temperatur des Leistungshalbleitermoduls bestimmt werden.

In einer Ausführungsform der Erfindung wird eine Kennlinie für das Leistungshalbleitermodul bestimmt, anhand welcher jedem Wert des zumindest einen temperatursensitiven elektrischen Parameters jeweils ein Temperaturwert zugeordnet wird, wobei einer der Temperaturwerte in Abhängigkeit des gemessenen temperatursensitiven elektrischen Parameters als die aktuelle Temperatur bestimmt wird. Diese Kennlinie wird insbesondere einmalig zu einem Kalibrierzeitpunkt, beispielsweise in dem gesunden Zustand des Leistungshalbleitermoduls, bestimmt. In dieser Kennlinie sind Werte des zumindest einen temperatursensitiven elektrischen Parameters über die Temperatur aufgetragen. Zu dem späteren Zeitpunkt kann anhand dieser vorgegebenen Kennlinie besonders schnell und ohne großen Rechenaufwand die zu dem Wert des im Betrieb gemessenen temperatursensitiven elektrischen Parameters korrespondierende Temperatur als die aktuelle Temperatur bestimmt werden. Bei einer kontinuierlichen Messung der temperatursensitiven elektrischen Parameter im Betrieb des Leistungshalbleitermoduls können somit insbesondere eine Echtzeitmessung der Temperaturdifferenz und damit eine Online-Lebensdauerüberwachung erfolgen. Damit kann eine fortschreitende Alterung des Leistungshalbleitermoduls frühzeitig erkannt werden.

Vorzugsweise wird die Kennlinie bestimmt, indem die Temperaturwerte für das Leistungshalbleitermodul vorgegeben werden, das Leistungshalbleitermodul auf den jeweiligen Temperaturwert temperiert beziehungsweise eingestellt wird und der jeweilige Wert des zumindest einen temperatursensitiven elektrischen Parameters bei dem vorgegebenen Temperaturwert gemessen wird. Mit anderen Worten bedeutet dies, dass die Temperatur des Leistungshalbleitermoduls aktiv auf die vorgegebenen Temperaturwerte eingestellt wird.

Zum Einstellen der Temperatur wird in einer Ausführungsform der Erfindung eine Heizeinrichtung bereitgestellt, mittels welcher das Leistungshalbleitermodul auf die jeweiligen vorgegebenen Temperaturwerte aufgeheizt werden kann.

Zum Bestimmen der Werte des zumindest einen temperatursensitiven elektrischen Parameter bei den verschiedenen vorgegebenen Temperaturwerten kann die Temperatur des Leistungshalbleitermoduls mittels der Heizeinrichtung stufenweise erhöht werden. Sobald sich das Leistungshalbleitermodul bei der durch die Heizeinrichtung bereitgestellten Temperatur mit dem vorgegebenen Temperaturwert in einem thermisch eingeschwungenen Zustand befindet, wird der jeweilige Wert des zumindest einen temperatursensitiven elektrischen Parameters gemessen. Somit kann jedem Temperaturwert eindeutig ein Wert des jeweiligen temperatursensitiven elektrischen Parameters zugeordnet werden. Durch diese Kalibrierung der temperatursensitiven elektrischen Parameter kann zu dem späteren Zeitpunkt die aktuelle Temperatur des Leistungshalbleitermoduls im Betrieb besonders schnell und einfach bestimmt beziehungsweise aus der Kennlinie ausgelesen werden.

Besonders bevorzugt erfolgt die Messung des zumindest einen temperatursensitiven elektrischen Parameters zum Bestimmen der Kennlinie in Abhängigkeit der vorgegebenen Temperatur mittels einer Doppelpuls-Messschaltung. Eine solche Doppelpuls-Messschaltung ist beispielsweise aus "Halbleiter-Leistungsbauelemente" (Josef Lutz, Springer-Verlag Berlin Heidelberg 2006, S. 126/127) bekannt. Dabei werden in dem thermisch eingeschwungenen Zustand des Leistungshalbleitermoduls zwei Spannungspulse am Gate-Emitter-Anschluss des oder der IGBTs erzeugt, die Einschalt- und Ausschaltvorgänge des oder der IGBTs erfasst und anschließend die temperatursensitiven elektrischen Parameter (TSEP) in Abhängigkeit der vorgegebenen Temperatur ausgewertet.

Die Erfindung umfasst außerdem eine Vorrichtung zum Charakterisieren eines Leistungshalbleitermoduls in einem Betrieb des Leistungshalbleitermoduls mit einer Messeinrichtung zum Messen zumindest eines temperatursensitiven elektrischen Parameters des Leistungshalbleitermoduls und einer Recheneinrichtung zum Ermitteln einer aktuellen Temperatur aus dem zumindest einen temperatursensitiven elektrischen Parameter zu zumindest einem gegenüber einem Referenzzeitpunkt, welcher vor einer Inbetriebnahme des Leistungshalbleitermoduls liegt, späteren Zeitpunkt, zum Berechnen einer Temperaturdifferenz zwischen einer vorgegebenen Referenztemperatur und der aktuellen Temperatur und zum Bestimmen einer Alterung des Leistungshalbleitermoduls anhand der ermittelten Temperaturdifferenz, wobei die Referenztemperatur anhand eines zu dem Referenzzeitpunkt bestimmten thermischen Modells ermittelt ist und wobei das thermische Modell anhand einer einen thermischen Pfad des Leistungshalbleitermoduls beschreibende thermische Impedanz des Leistungshalb-

leitermoduls bestimmt ist. Die Vorrichung dient zu einer Online-Überwachung der Temperaturdifferenz, also zu einer kontinuierlichen Überwachung der Temperaturdifferenz, und damit zu einer kontinuierlichen Überwachung der verbleibenden Lebensdauer in einem Betrieb des Leistungshalbleitermoduls.

Zur Erfindung gehört außerdem eine Schaltungsanordnung aufweisend ein Leistungshalbleitermodul mit zumindest einem Leistungshalbleiterbauelement und eine erfindungsgemäße Vorrichtung zum Bestimmen der Alterung des Leistungshalbleitermoduls.

Bevorzugt umfasst das Leistungshalbleitermodul einen Wechselrichter und zumindest einen Kühlkörper, wobei der Wechselrichter als das zumindest eine Leistungshalbleiterbauelement zumindest einen IGBT aufweist.

Gemäß einer Weiterbildung der Schaltungsanordnung umfasst die Schaltungsanordnung eine Steuereinrichtung, welche dazu ausgelegt ist, anhand der ermittelten Temperaturdifferenz eine Leistung des Leistungshalbleitermoduls zu regeln.

Die mit Bezug auf das erfindungsgemäße Verfahren vorgestellten bevorzugten Ausführungsformen und deren Vorteile gelten entsprechend für die erfindungsgemäße Vorrichtung sowie für die erfindungsgemäße Schaltungsanordnung.

Im Folgenden wird die Erfindung nun anhand eines bevorzugten Ausführungsbeispiels wie auch unter Bezugnahme auf die beigefügten Zeichnungen näher erläutert.

Es zeigen:

FIG 1     eine schematische Darstellung eines Leistungshalbleitermoduls, an welchem eine Ausführungsform des erfindungsgemäßen Verfahrens zur Bestimmung einer Alterung des Leistungshalbleitermoduls durchgeführt wird;

FIG 2     eine schematische Darstellung einer Messschaltung zur Messung von temperatursensitiven elektrischen Parametern eines Leistungshalbleiterbauelementes sowie dazugehörige Kennlinien des Leistungshalbleiterbauelementes; und

FIG 3     eine schematische Darstellung einer Doppelpuls-Messschaltung zum Durchführen eines Doppelpulsversuches mit zugehörigen Eingangs- und Ausgangskennlinien.

Bei dem im Folgenden erläuterten Ausführungsbeispiel handelt es sich um eine bevorzugte Ausführungsform der Erfindung. Bei dem Ausführungsbeispiel stellen aber die beschriebenen Komponenten der Ausführungsform jeweils einzelne, unabhängig voneinander zu betrachtende Merkmale der Erfindung dar, welche die Erfindung auch jeweils unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

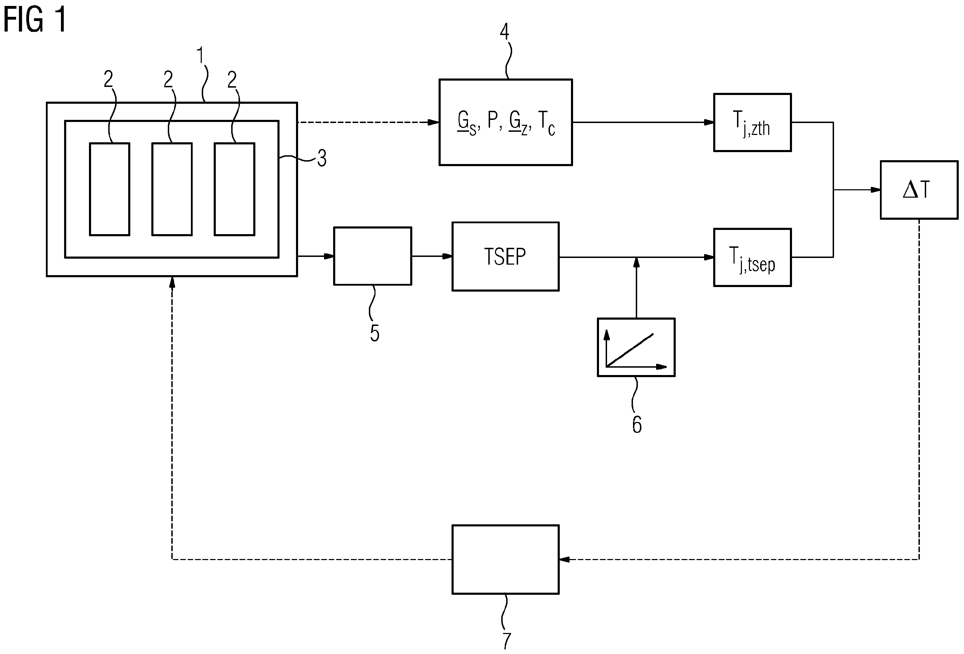

FIG 1 zeigt schematisch ein Leistungshalbleitermodul 1, welches hier mehrere Leistungshalbleiterbauelemente 2 aufweist. Darüber hinaus weist das Leistungshalbleitermodul 1 hier einen Kühlkörper 3 auf, auf welchem die Leistungshalbleiterbauelemente 2 angeordnet sind und welcher zum Kühlen der Leistungshalbleiterbauelemente 2 im Betrieb des Leistungshalbleitermoduls 1 dient. Üblicherweise sind dabei die geometrischen Abmessungen des Kühlkörpers 3 größer als die der zusammen geschalteten Leistungshalbleiterbauelemente 2. Das Leistungshalbleitermodul 1 kann beispielsweise als ein Umrichter oder als ein Wechselrichter ausgestaltet sein. Die Leistungshalbleiterbauelemente 2 können beispielsweise IGBTs sein.

Im Betrieb des Leistungshalbleitermoduls 1 ist dieses beispielsweise thermischen Belastungen ausgesetzt, durch welche das Leistungshalbleitermodul 1 altert. Diese Alterung kann zu einer Verkürzung einer Lebensdauer beziehungsweise einer Funktionstüchtigkeit des Leistungshalbleitermoduls 1 und zu einem verfrühten Ausfall des Leistungshalbleitermoduls 1 führen. Ziel des im Folgenden beschriebenen Verfahrens ist es, die Alterung des Leistungshalbleitermoduls 1 im Betrieb des Leistungshalbleitermoduls 1 zu bestimmen und damit eine verbleibende Lebensdauer beziehungsweise Verfügbarkeit des Leistungshalbleitermoduls 1 vorherzusagen.

Zu einem Referenzzeitpunkt, zu welchem das Leistungshalbleitermodul 1 einen gesunden, ungealterten Zustand aufweist, wird ein thermisches Modell 4 des Leistungshalbleitermoduls 1 bestimmt. Das thermische Modell 4 umfasst hier Matrizen $\underline{G}_S$ und $\underline{G}_Z$, welche Übertragungsfunktionen enthalten. Diese Übertragungsfunktionen beschreiben einen thermischen Pfad des Leistungshalbleitermoduls 1 und können aus den gemessenen thermischen Impedanzen der Leistungshalbleiterbauelemente 2 berechnet werden. Außerdem umfasst das thermische Modell 4 hier Wärmequellen beziehungsweise Wärmesenken innerhalb des Leistungshalbleitermoduls 1, welcher hier über eine Verlustleistung P beziehungsweise Wärmeleistung sowie über eine Kühlkörpertemperatur $T_C$ des Kühlkörpers 3 angegeben beziehungsweise charakterisiert werden. Auch kann der thermische Pfad eine Gehäusetemperatur sowie eine Wärmeleitpaste umfassen. Die Verlustleistung P kann im Arbeitspunkt des Leistungshalbleitermoduls 1 aus einer zu dem Referenzzeitpunkt gemessenen Ausgangsspannung und aus einem zu dem Referenzzeitpunkt gemessenen Ausgangsstrom berechnet werden. Die Kühlkörpertemperatur $T_C$ wird im Betrieb des Leistungshalbleitermoduls 1 gemessen.

Aus dem thermischen Modell 4 wird eine Referenztemperatur $T_{j,zth}$ bestimmt. Die Referenztemperatur $T_{j,zth}$ kann anhand folgender Gleichung bestimmt werden:

$$T_{j,zth} = \underline{G}_S * P + \underline{G}_Z * T_C,$$

wobei * ein Faltungsoperator ist.

Zu einem späteren Zeitpunkt, welcher zeitlich nach dem Referenzzeitpunkt liegt, kann, beispielsweise mittels einer Messschaltung 5 zumindest ein temperatursensitiver elektrischer Parameter TSEP im Betrieb des Leistungshalbleitermoduls 1 bestimmt werden. Ein solcher temperatursensitiver elektrischer Parameter TSEP kann beispielsweise eine Schwellenspannung (Gate-Emitter Spannung), ein Millerplateau, eine Einschaltverzögerungszeit, eine Ausschaltverzögerungszeit, eine Stromanstiegsgeschwindigkeit, eine Sperrverzugsladung, ein Tailstrom, eine Spannungsspitze zwischen Emitter und Hilfsemitter während eines Einschaltvorgangs sowie eine Ein- und eine Ausschaltdauer des Leistungshalbleitermoduls 1 sein. Anhand des bestimmten temperatursensitiven elektrischen Parameters TSEP wird eine aktuelle Temperatur $T_{j,tsep}$ des Leistungshalbleitermoduls 1 bestimmt. Die Bestimmung der aktuellen Temperatur $T_{j,tsep}$ kann beispielsweise mittels einer vorgegebenen Kennlinie 6 erfolgen. In der Kennlinie 6 sind Werte für einen temperatursensitiven elektrischen Parameter über der Temperatur aufgetragen. Die Kennlinie 6 kann beispielsweise zu einem Kalibrierzeitpunkt insbesondere vor Inbetriebnahme des Leistungshalbleitermoduls 1 bestimmt worden sein. Dazu wurde das Leistungshalbleitermodul 1 auf vorgegebene Temperaturwerte eingestellt, beispielsweise geheizt, bei dem vorgegebenen, eingestellten Temperaturwert der entsprechende temperatursensitive elektrische Parameter gemessen und die jeweiligen Wertepaare in der Kennlinie 6 dargestellt.

Wenn schließlich im Betrieb der zumindest eine temperatursensitive elektrische Parameter TSEP, beispielsweise mittels der Messschaltung 5, erfasst wird, kann mittels der vorgegebenen Kennlinie 6 auf besonders einfache und schnelle Weise die aktuelle Temperatur $T_{j,tsep}$ des Leistungshalbleitermoduls 1 ermittelt werden. Die Erfassung des zumindest einen temperatursensitiven elektrischen Parameters TSEP kann beispielsweise kontinuierlich oder zu vorgegebenen Messzeitpunkten während des Betriebs des Leistungshalbleitermoduls 1 erfolgen.

Aus der aktuellen Temperatur $T_{j,tsep}$ und der Referenztemperatur $T_{j,zth}$ wird eine Temperaturdifferenz ΔT gebildet, wobei $\Delta T = |T_{j,tsep} - T_{j,tsep}|$. Anhand der Temperaturdifferenz ΔT kann eine Alterung des Leistungshalbleitermoduls 1 bestimmt werden, da sich die aktuelle Temperatur $T_{j,tsep}$, beispielsweise aufgrund von Verschleißerscheinungen am Leistungshalbleitermodul 1, verändert. In einem ungealterten Zustand ist die Temperaturdifferenz ΔT Null, also ΔT = 0. Mit fortschreitender Alterung erhöht sich die Temperaturdifferenz ΔT zunehmend. Die relative Änderung der Temperatur gibt also Aufschluss über ein alterndes Leistungshalbleitermodul 1. Bei einer kontinuierlichen Erfassung der er temperatursensitiven elektrischen Parameter TSEP und einer kontinuierlichen Bestimmung der Temperaturdifferenz ΔT kann eine Alterung des Leistungshalbleitermoduls 1 kontinuierlich überwacht werden und ein möglicher bevorstehender Ausfall des Leistungshalbleitermoduls 1 frühzeitig erkannt werden.

Zu einer Verlängerung der Restlebensdauer kann die Temperaturdifferenz ΔT beispielsweise einer Steuereinrichtung 7 bereitgestellt werden, welche dazu ausgelegt ist, eine Leistung des Leistungshalbleitermoduls 1 in Abhängigkeit der Temperaturdifferenz ΔT zu regeln. Dadurch können erhöhte Betriebstemperaturen und Temperaturwechselbelastungen und damit eine fortschreitende Alterung des Leistungshalbleitermoduls 1 vermieden werden.

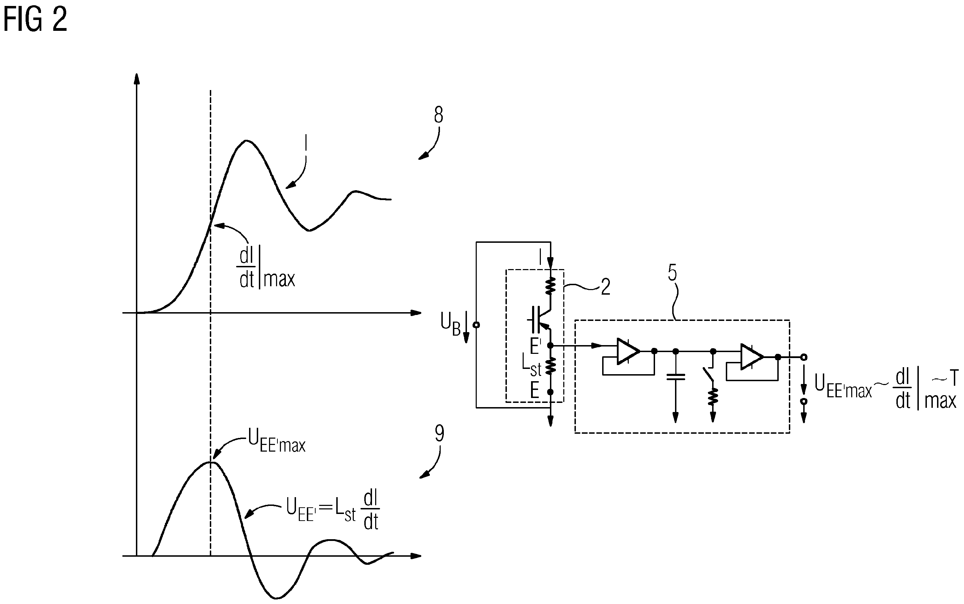

FIG 2 zeigt ein Beispiel für eine Messschaltung 5 zur Messung von temperatursensitiven elektrischen Parametern TSEP eines Leistungshalbleiterbauelementes 2 sowie zwei Kennlinien 8 und 9. In der oberen Kennlinie 8 ist ein Stromverlauf I bei einem Einschaltvorgang des Leistungshalbleiterbauelementes 2 dargestellt. In der unteren Kennlinie 9 ist ein Spannungsabfall $U_{EE'}$ an einer Streuinduktivität $L_{st}$ zwischen einem Emitteranschluss E des Leistungshalbleiterbauelementes 2 und einem sogenannten Hilfsemitter E' des Halbleiterleistungsbauelementes 2 dargestellt. Mittels der Messschaltung 5 werden hier als die temperatursensitiven elektrischen Parameter TSEP eine maximale Stromanstiegsgeschwindigkeit $dI/dt|_{max}$ und daraus eine Spannungsspitze $U_{EE'max}$ während eines Einschaltvorgangs des Leistungshalbleiterbauelementes 2 bestimmt.

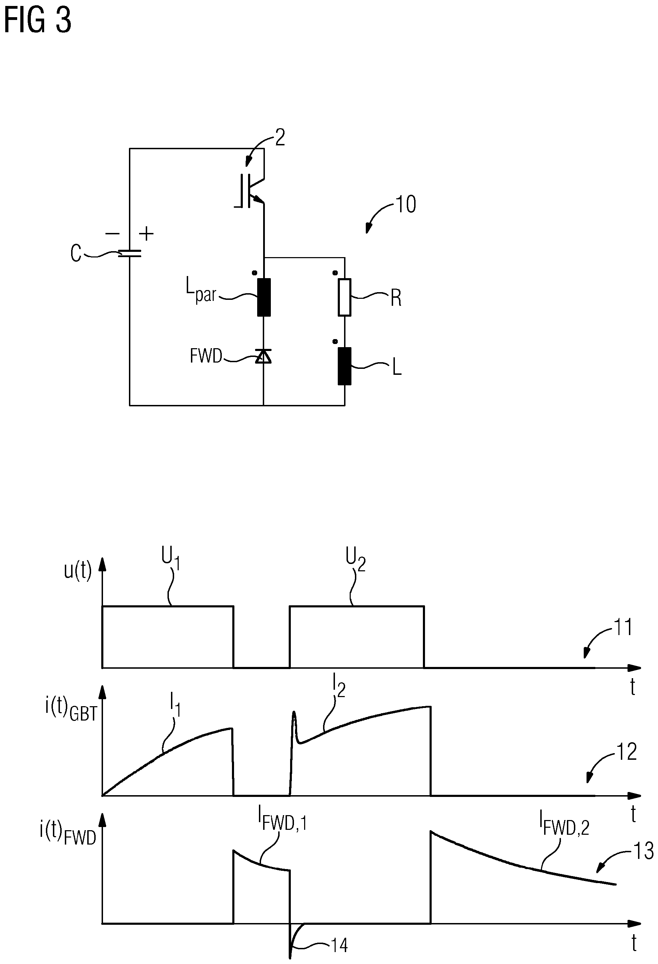

FIG 3 zeigt eine Doppelpuls-Messschaltung 10 zum Durchführen eines Doppelpulsversuches mit einer Eingangskennlinie 11 und zwei Ausgangskennlinien 12 und 13. Diese Messschaltung 10 sowie die Kennlinien 11, 12 und 13 sind aus "Halbleiter-Leistungsbauelemente" (Josef Lutz, Springer-Verlag Berlin Heidelberg 2006, S. 126/127) bekannt. Der Doppelpulsversuch kann beispielsweise zur Messung temperatursensitiver elektrischer Parameter TSEP, beispielsweise einer Rückstromspitze 14, bei vorgegebener Temperatur zur Erstellung der Kennlinie 6 verwendet werden.

Die Doppelpuls-Messschaltung 10 umfasst das als IGBT ausgebildete Halbleiterleistungsbauelement 2, einen Kondensator C, einen Widerstand R und eine Spule L, welche eine ohmschinduktive Last ausbilden, eine Freilaufdiode FWD, sowie eine parasitäre Induktivität $L_{par}$, welche aufgrund der Leitungen zwischen dem Kondensator C, dem Halbleiterleistungsbauelement 2 und der Diode FWD ausgebildet ist.

Zur Messung wird ein erster Spannungspuls $U_1$ am Eingang des Halbleiterleistungsbauelementes 2 erzeugt, welcher in Kennlinie 11 über die Zeit t aufgetragen dargestellt ist. Der Stromverlauf $I_1$ des Halbleiterleistungsbauelementes 2 während des ersten Spannungspuls $U_1$ ist in Kennlinie 12 über die Zeit t aufgetragen dargestellt. Nach Ausschalten des Halbleiterleistungsbauelementes 2, also nach dem ersten Spannungspuls

U$_1$, wird der Strom I$_{FWD,1}$ von der Freilaufdiode FWD übernommen, deren Stromverlauf in Kennlinie 13 über die Zeit t aufgetragen dargestellt ist. Mit dem nächsten Einschalten des Halbleiterleistungsbauelementes 2, also mit dem zweiten Spannungspuls U$_2$ am Eingang des Halbleiterleistungsbauelementes 2, wird die Diode FWD kommutiert und das Halbleiterleistungsbauelement 2 übernimmt beim Einschalten den zusätzlichen Rückstrom 14 der Diode FWD, welcher als der temperatursensitive elektrische Parameter TSEP bei der vorgegebenen Temperatur erfasst wird.

**Patentansprüche**

1. Verfahren zum Charakterisieren eines Leistungshalbleitermoduls (1) aufweisend zumindest ein Leistungshalbleiterbauelement (2) mit den Schritten:

    - Bestimmen eines thermischen Modells (4) des Leistungshalbleitermoduls (1) zu einem Referenzzeitpunkt, welcher vor einer Inbetriebnahme des Leistungshalbleitermoduls (1) liegt, wobei zum Erstellen des thermischen Modells (4) eine einen thermischen Pfad des Leistungshalbleitermoduls (1) beschreibende thermische Impedanz des Leistungshalbleitermoduls (1) bestimmt wird,
    - Ermitteln einer Referenztemperatur (T$_{j,zth}$) anhand des thermischen Modells (4) des Leistungshalbleitermoduls (1),
    - Messen zumindest eines temperatursensitiven elektrischen Parameters (TSEP) des Leistungshalbleitermoduls (1) zu zumindest einem gegenüber dem Referenzzeitpunkt späteren Zeitpunkt im Betrieb des Leistungshalbleitermoduls (1),
    - Ermitteln einer aktuellen Temperatur (T$_{j,tsep}$) des Leistungshalbleitermoduls (1) aus dem zumindest einen gemessenen temperatursensitiven elektrischen Parameter (TSEP) des Leistungshalbleitermoduls (1),
    - Ermitteln einer Temperaturdifferenz (ΔT) zwischen der aktuellen Temperatur (T$_{j,tsep}$) und der Referenztemperatur (T$_{j,zth}$) und
    - Bestimmen einer Alterung des Leistungshalbleitermoduls (1) anhand der ermittelten Temperaturdifferenz (ΔT).

2. Verfahren nach Anspruch 1, wobei zum Erstellen des thermischen Modells (4) eine Verlustleistung (P) des Leistungshalbleitermoduls (1) bestimmt wird.

3. Verfahren nach einem der vorhergehenden Ansprüche, wobei zum Erstellen des thermischen Modells (4) eine Temperatur (T$_c$) eines Kühlkörpers (3) des Leistungshalbleitermoduls (1) im Betrieb des Leistungshalbleitermoduls (1) erfasst wird.

4. Verfahren nach einem der vorhergehenden Ansprüche, wobei ein Leistungshalbleitermodul (1) charakterisiert wird, welches als das zumindest eine Leistungshalbleiterbauelement (2) einen IGBT aufweist.

5. Verfahren nach Anspruch 4, wobei als der zumindest eine temperatursensitive elektrische Parameter (TSEP) eine elektrische Schwellenspannung und/oder ein Millerplateau und/oder eine Einschaltverzögerungszeit und/oder eine Ausschaltverzögerungszeit und/oder eine maximale Stromanstiegsgeschwindigkeit (dI/dt|$_{max}$ ) und/oder eine Sperrverzugsladung und/oder ein Tailstrom und/oder ein Spannungsspitze (U$_{EE'max}$) während eines Einschaltvorgangs und/oder eine Einschaltdauer und/oder eine Ausschaltdauer gemessen wird.

6. Verfahren nach einem der vorhergehenden Ansprüche, wobei eine Kennlinie (6) bestimmt wird, anhand welcher jedem Wert des zumindest einen temperatursensitiven elektrischen Parameters (TSEP) ein Temperaturwert zugeordnet wird, wobei einer der Temperaturwerte in Abhängigkeit des gemessenen temperatursensitiven elektrischen Parameters (TSEP) als die aktuelle Temperatur (T$_{j,tsep}$) bestimmt wird.

7. Verfahren nach Anspruch 6, wobei zum Bestimmen der Kennlinie (6) die Temperaturwerte für das Leistungshalbleitermodul (1) vorgegeben werden, das Leistungshalbleitermodul (1) auf den jeweiligen vorgegeben Temperaturwert temperiert wird und der jeweilige Wert des zumindest einen temperatursensitiven elektrischen Parameters (TSEP) bei dem vorgegebenen Temperaturwert gemessen wird.

8. Verfahren nach Anspruch 7, wobei zum Einstellen der Temperaturwerte eine Heizeinrichtung bereitgestellt wird, mittels welcher eine Temperatur des Leistungshalbleitermoduls (1) auf die jeweiligen vorgegebenen Temperaturwerte stufenweise erhöht wird.

9. Verfahren nach Anspruch 7 oder 8, wobei die Messung des zumindest einen temperatursensitiven elektrischen Parameters (TSEP) zum Erstellen der Kennlinie (6) bei dem jeweiligen vorgegebenen Temperaturwert mittels einer Doppelpuls-Messschaltung (10) durchgeführt wird.

10. Vorrichtung zum Charakterisieren eines Leistungshalbleitermoduls (1) in einem Betrieb des Leistungshalbleitermoduls (1) mit einer Messeinrichtung zum Messen zumindest eines temperatursensitiven elektrischen Parameters (TSEP) des Leistungshalbleitermoduls (1) und einer Recheneinrichtung zum Ermitteln einer aktuellen Temperatur (T$_{j,tsep}$) aus dem zumindest einen temperatursensitiven elektrischen Parameter (TSEP) zu zumindest einem gegenüber einem Referenzzeitpunkt, welcher vor einer Inbetriebnahme des Leistungshalbleitermoduls (1) liegt, späteren Zeitpunkt, zum Berechnen einer Temperaturdifferenz ($\Delta T$) zwischen einer vorgegebenen Referenztemperatur ($T_{j,zth}$) und der aktuellen Temperatur ($T_{j,tsep}$) und zum Bestimmen einer Alterung des Leistungshalbleitermoduls (1) anhand der ermittelten Temperaturdifferenz ($\Delta T$), wobei die Referenztemperatur ($T_{j,zth}$) anhand eines zu dem Referenzzeitpunkt bestimmten thermischen Modells (4) ermittelt ist und wobei das thermische Modell(4) anhand einer einen thermischen Pfad des Leistungshalbleitermoduls (1) beschreibende thermische Impedanz des Leistungshalbleitermoduls (1) bestimmt ist.

11. Schaltungsanordnung aufweisend ein Leistungshalbleitermodul (1) mit zumindest einem Leistungshalbleiterbauelement (2) und eine Vorrichtung nach Anspruch 10.

12. Schaltungsanordnung nach Anspruch 11, wobei das Leistungshalbleitermodul (1) einen Wechselrichter und zumindest einen Kühlkörper (3) umfasst, wobei der Wechselrichter als das zumindest eine Leistungshalbleiterbauelement (2) zumindest einen IGBT aufweist.

13. Schaltungsanordnung nach Anspruch 11 oder 12, wobei die Schaltungsanordnung eine Steuereinrichtung (7) aufweist, welche dazu ausgelegt ist, eine Leistung des Leistungshalbleitermoduls (2) in Abhängigkeit der ermittelten Temperaturdifferenz ($\Delta T$) zu regeln.

**Claims**

1. Method for characterising a power semiconductor module (1), which has at least one power semiconductor component (2) with the steps:

   - Determining a thermal model (4) of the power semiconductor module (1) at a reference time point, which lies before a commissioning of the power semiconductor module (1), wherein, for creation of the thermal model (4), a thermal impedance of the power semiconductor module (1) describing a thermal path of the power semiconductor module (1) is determined,
   - Establishing a reference temperature ($T_{j,zth}$) on the basis of the thermal model (4) of the power semiconductor module (1),
   - Measuring at least one temperature-sensitive electrical parameter (TSEP) of the power semiconductor module (1) at at least one later point in time compared to the reference time point, during operation of the power semiconductor module (1),
   - Establishing a current temperature ($T_{j,tsep}$) of the power semiconductor module (1) from the at least one measured temperature-sensitive electrical parameter (TSEP) of the power semiconductor module (1),
   - Establishing a temperature difference ($\Delta T$) between the current temperature ($T_{j,tsep}$) and the reference temperature ($T_{j,zth}$) and
   - Determining a deterioration of the power semiconductor module (1) on the basis of the temperature difference ($\Delta T$) established.

2. Method according to claim 1, wherein, for creation of the thermal model (4), a power dissipation (P) of the power semiconductor module (1) is determined.

3. Method according to one of the preceding claims, wherein, for creation of the thermal model (4), a temperature ($T_c$) of a cooling element (3) of the power semiconductor module (1) is acquired during operation of the power semiconductor module (1).

4. Method according to one of the preceding claims, wherein a power semiconductor module (1) is characterised, which has an IGBT as the at least one power semiconductor component (2).

5. Method according to claim 4, wherein an electrical threshold voltage and/or a Miller plateau and/or a turn-on delay time and/or a turn-off delay time and/or a maximum speed of current increase ($dI/dt|_{max}$) and/or a recovered charge and/or a tail current and/or a voltage peak ($U_{EE'max}$) during a turn-on process and/or a turn-on duration and/or a turn-off duration is measured as the at least one temperature-sensitive electrical parameter (TSEP).

6. Method according to one of the preceding claims, wherein a characteristic curve (6) is determined, on the basis of which each value of the at least one temperature-sensitive electrical parameter (TSEP) is assigned a temperature value, wherein one of the temperature values is determined as a function of the measured temperature-sensitive electrical parameter (TSEP) as the current temperature ($T_{j,tsep}$).

7. Method according to claim 6, wherein, for determining the characteristic curve (6), the temperature values are predetermined for the power semiconductor module (1), the power semiconductor module (1) is set to the respective temperature value and the respective value of the at least one temperature-sensitive electrical parameter (TSEP) is measured at the predetermined temperature value.

8. Method according to claim 7, wherein a heating device is provided for setting the temperature values, by means of which a temperature of the power semiconductor module (1) is increased step-by-step to the respective predetermined temperature values.

9. Method according to claim 7 or 8, wherein the measurement of the at least one temperature-sensitive electrical parameter (TSEP) for creating the characteristic curve (6) is carried out at the respective predetermined temperature value by means of a double-pulse measurement circuit (10).

10. Device for characterising a power semiconductor module (1) during operation of the power semiconductor module (1) with a measuring device for measuring at least one temperature-sensitive electrical parameter (TSEP) of the power semiconductor module (1) and a calculation device for establishing a current temperature ($T_{j,tsep}$) from the at least one temperature-sensitive electrical parameter (TSEP) at at least one later point in time compared to a reference time point, which lies before a commissioning of the power semiconductor module (1), for calculating a temperature difference ($\Delta T$) between a predetermined reference temperature ($T_{j,zth}$) and the current temperature ($T_{j,tsep}$) and for determining a deterioration of the power semiconductor module (1) on the basis of the temperature difference established ($\Delta T$), wherein the reference temperature ($T_{j,zth}$) is established on the basis of a thermal model (4) determined at the reference time point and wherein the thermal model (4) is determined on the basis of a thermal impedance of the power semiconductor module (1) describing a thermal path of the power semiconductor module (1) .

11. Circuit arrangement, which has a power semiconductor module (1) with at least one power semiconductor component (2) and a device according to claim 10.

12. Circuit arrangement according to claim 11, wherein the power semiconductor module (1) comprises an inverter and at least one cooling element (3), wherein the inverter has at least one IGBT as the at least one power semiconductor component (2).

13. Circuit arrangement according to claim 11 or 12, wherein the circuit arrangement has a control device (7), which is designed to regulate a power of the power semiconductor module (2) as a function of the temperature difference ($\Delta T$) established.

**Revendications**

1. Procédé de caractérisation d'un module (1) à semi-conducteur de puissance comportant au moins un composant (2) à semi-conducteur de puissance ayant les stades :

- détermination d'un modèle (4) thermique du module (1) à semi-conducteur de puissance à un instant de référence, qui est avant une mise en service du module (1) à semi-conducteur de puissance, dans lequel, pour établir le modèle (4) thermique, on détermine une impédance du module (1) à semi-conducteur de puissance décrivant un trajet thermique du module (1) à semi-conducteur de puissance,
- détermination d'une température ($T_{j, zth}$) de référence à l'aide du modèle (4) thermique du module (1) à semi-conducteur de puissance,
- mesure au moins d'un paramètre (TSEP) électrique, sensible à la température, du module (1) à semi-conducteur de puissance à au moins un instant ultérieur par rapport à l'instant de référence, alors que le module (1) à semi-conducteur de puissance est en fonctionnement,
- détermination d'une température ($T_{j, tsep}$) présente du module (1) à semi-conducteur de puissance à partir du au moins un paramètre (TSEP) électrique, sensible à la température qui a été mesurée, du module (1) à semi-conducteur de puissance,
- détermination d'une différence ($\Delta T$) de température, entre la température ($T_{j, tsep}$) présente et la température ($T_{j, zth}$) de référence et
- détermination d'un vieillissement du module (1) à semi-conducteur de puissance à l'aide de la différence ($\Delta T$) de température, qui a été déterminée.

2. Procédé suivant la revendication 1, dans lequel, pour établir le modèle (4) thermique, on détermine une perte (P) de puissance du module (1) à semi-conducteur de puissance.

3. Procédé suivant l'une des revendications précédentes, dans lequel pour établir le modèle (4) thermique, on relève, alors que le module (1) à semi-conducteur de puissance est en fonctionnement, une température ($T_c$) d'un puits (3) de chaleur du module (1) à semi-conducteur de puissance.

4. Procédé suivant l'une des revendications précédentes, dans lequel on caractérise un module (1) à semi-conducteur de puissance, qui a un IGBT, comme le au moins un composant (2) à semi-conducteur de puissance.

5. Procédé suivant la revendication 4, dans lequel on mesure, comme le au moins un paramètre (TSEP) électrique, sensible à la température, une tension électrique de seuil et/ou un plateau de Miller et/ou un temps de retard de passage à l'état conducteur et/ou un temps de retard de passage à l'état bloqué et/ou une vitesse $(DI/dt|_{max})$ maximum de l'augmentation de courant et/ou une charge recouvrée et/ou un courant de queue et/ou une pointe $(U_{EE'max})$ de tension pendant un processus de passage à l'état conducteur et/ou une durée de passage à l'état conducteur et/ou une durée de passage à l'état bloqué.

6. Procédé suivant l'une des revendications précédentes, dans lequel on détermine une courbe (6) caractéristique, à l'aide de laquelle on affecte à chaque valeur du au moins un paramètre (TSEP) électrique, sensible à la température, une valeur de température, dans lequel l'une des valeurs de température est définie en fonction du paramètre (TSEP) électrique, sensible à la température, qui a été mesuré, comme étant la température $((T_{j,\ tsep})$ présente.

7. Procédé suivant la revendication 6, dans lequel pour déterminer la courbe (6) caractéristique, on donne à l'avance les valeurs de température pour le module (1) à semi-conducteur de puissance, on met le module (1) à semi-conducteur de puissance en température à la valeur de température donnée à l'avance et on mesure, à la valeur de la température donnée à l'avance, la valeur du au moins un paramètre (TSEP) électrique sensible à la température.

8. Procédé suivant la revendication 7, dans lequel, pour établir les valeurs de température, on se procure un dispositif de chauffage au moyen duquel on élève, par palier, une température du module (1) à semi-conducteur de puissance aux valeurs de température données à l'avance.

9. Procédé suivant la revendication 7 ou 8, dans lequel on effectue la mesure du au moins un paramètre (TSEP) électrique sensible à la température afin d'établir la courbe (6) caractéristique à la valeur de température donnée à l'avance au moyen d'un circuit (10) de mesure à double impulsion.

10. Dispositif de caractérisation d'un module (1) à semi-conducteur de puissance, alors que le module (1) à semi-conducteur de puissance est en fonctionnement, comprenant un dispositif de mesure pour mesurer au moins un paramètre (TSEP) électrique sensible à la température du module (1) à semi-conducteur de puissance, et dispositif informatique pour déterminer une température $(T_{j,\ tsep})$ présente à partir du au moins un paramètre (TSEP) électrique sensible à la température à au moins un instant ultérieur par rapport à un instant de référence qui est antérieur à une mise en service du module (1) à semi-conducteur de puissance, pour calculer une différence $(\Delta T)$ de température entre une température $(T_{j,\ zth})$ de référence donnée à l'avance et la température $(t_{j,\ tsep})$ présente et pour déterminer un vieillissement du module (1) à semi-conducteur de puissance à l'aide de

la différence $(\Delta T)$ de température qui a été déterminée, la température $(T_{j,\ zth})$ de référence étant déterminée à l'aide d'un modèle (4) thermique déterminé à l'instant de référence, et dans lequel le modèle (4) thermique est déterminé à l'aide d'une impédance thermique du module (1) à semi-conducteur de puissance décrivant un trajet thermique du module (1) à semi-conducteur de puissance.

11. Montage comportant un module (1) à semi-conducteur de puissance ayant au moins un composant (2) à semi-conducteur de puissance et un dispositif suivant la revendication 10.

12. Montage suivant la revendication 11, dans lequel le module (1) à semi-conducteur de puissance comprend un onduleur et au moins un puits (3) de chaleur, l'onduleur ayant au moins un IGBT comme le au moins un composant (2) à semi-conducteur de puissance.

13. Montage suivant la revendication 11 ou 12, dans lequel le montage a un dispositif (7) de commande conçu pour réguler une puissance du module (2) à semi-conducteur de puissance en fonction de la différence $(\Delta T)$ de température qui a été déterminée.

FIG 1

$\underline{G}_S$, P, $\underline{G}_z$, $T_c$

$T_{j,zth}$

$\Delta T$

TSEP

$T_{j,tsep}$

EP 3 224 631 B1

FIG 2

EP 3 224 631 B1

$\dfrac{dI}{dt}\bigg|_{max}$

I

8

$U_B$

I

2

5

E'

$L_{st}$

E

9

$U_{EE'max}$

$U_{EE'}=L_{st}\dfrac{dI}{dt}$

$U_{EE'max}\sim\dfrac{dI}{dt}\bigg|_{max}\sim T$

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2615467 A1
- DE 102012222481 A1
- DE 10351843 A1

**In der Beschreibung aufgeführte Nicht-Patentliteratur**

- **JOSEF LUTZ.** Halbleiter-Leistungsbauelemente. Springer-Verlag, 2006, 126, , 127